# EUROPÄISCHE PATENTSCHRIFT

(11) **EP 0 279 291 B1**
(45) Veröffentlichungstag und Bekanntmachung des Hinweises auf die Patenterteilung: **21.07.1993**
(21) Anmeldenummer: 88101631.5
(22) Anmeldetag: 04.02.1988
(51) Int. Cl.: G01R 33/035

(54) **Vorrichtung zur Messung extrem niederfrequenter Magnetfelder mittels eines SQUID-Magnetometers**
Apparatus for the measurement of very low frequency magnetic fields using a SQUID magnetometer
Dispositif de mesure des champs magnétiques à fréquence très basse au moyen d'un magnétomètre à SQUID

(30) Priorität: 16.02.1987 DE 3704834
(43) Veröffentlichungstag der Anmeldung: 24.08.1988
(73) Patentinhaber: DORNIER GMBH, D-88004 Friedrichshafen (DE)
(72) Erfinder: Hoenig, Eckhardt, Dr., W-8520 Erlangen (DE)
(74) Vertreter: Landsmann, Ralf, Dipl.-Ing.

(56) Entgegenhaltungen:
- EP-A- 0 212 452
- US-A- 3 454 875
- MICROELECTRONIC ENGINEERING, Band 3, 1985, Seiten 221-234, Elsevier Science Publishers B.V., Amsterdam, NL; L. CSEPREGI: "Micromechanics: A silicon microfabrication technology"

## Beschreibung

Die Erfindung bezieht sich auf eine Vorrichtung zur Messung sich nur mit extrem geringer Frequenz ändernder magnetischer Felder mittels eines SQUID-Magnetometers, das einen supraleitenden Flußtransformator zur induktiven Einkopplung des Meßsignals in einen Sensor mit einem Gleichstrom-SQUID aufweist und das eine Einrichtung zur Modulation des Meßsignals enthält.

Mit SQUIDs (supraleitenden Quanteninterferometern) lassen sich Magnetometer hoher Magnetfeldempfindlichkeit, z.B. in der Größenordnung von 10⁻¹⁴ Tesla . (Hertz)^{-1/2} aufbauen. Ein entsprechendes Magnetometer enthält im allgemeinen neben einem SQUID-Sensor noch einen Flußtransformator, mit dem das zu detektierende Magnetfeld induktiv in den SQUID-Sensor eingekoppelt werden kann.

Bei derartigen Magnetometern ist die äußerste Grenze für ihre Empfindlichkeit durch das sogenannte 1/f-Rauschen bestimmt. Diese Grenze ist also umgekehrt proportional zur Frequenz (vgl. z.B. "Journal of Low Temperature Physics", Vol. 51, Nos. 1/2, 1983, Seiten 207 bis 224).

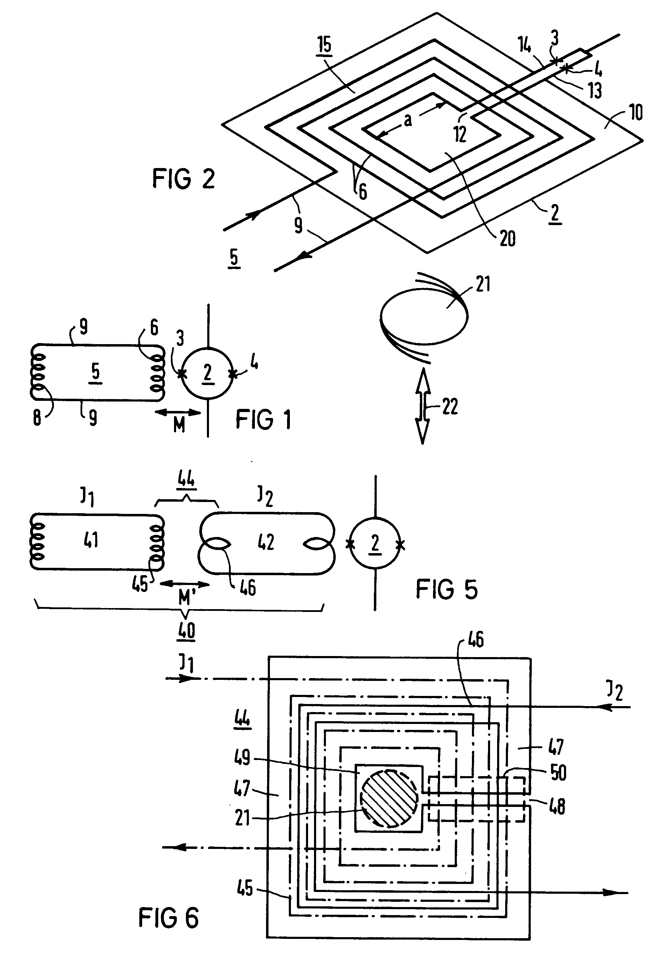

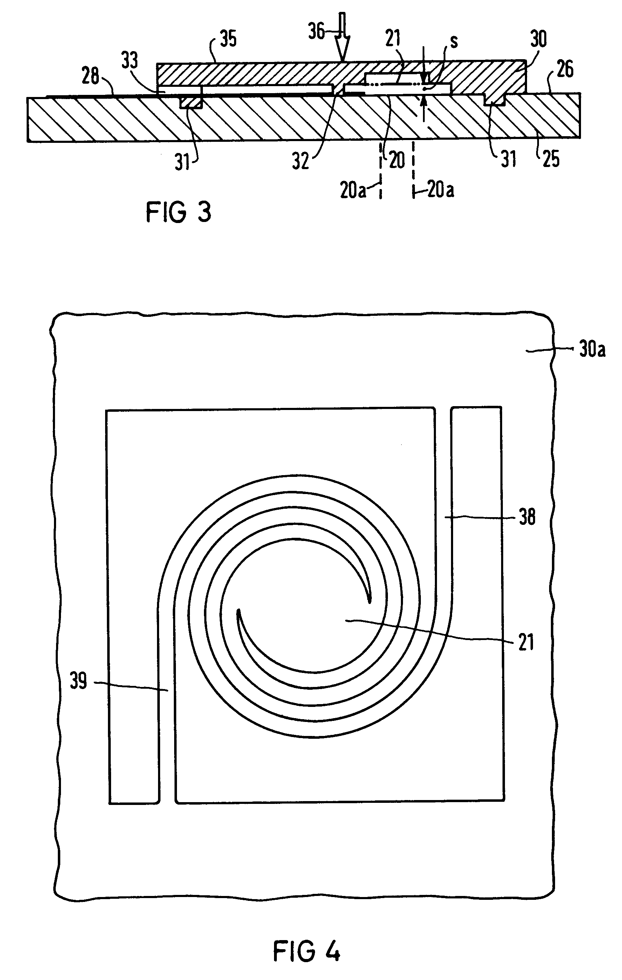

Aus der Veröffentlichung "SQUID-Superconducting Quantum Interference Devices and their Applications" (Proc.Int.Conf. on Supercond. Quantum Devices, Berlin 1976), 1977, Seiten 439 bis 484 ist eine Vorrichtung zur Unterwasser-Kommunikation zu entnehmen, mit der auch magnetische Felder mit extrem geringen Frequenzen von 30 bis 3000 Hz zu detektieren sind. Diese Vorrichtung weist unter anderem ein RF-SQUID als Sensor auf, der zusammen mit einem supraleitenden Flußtransformator in einem Kryostaten angeordnet ist (vgl. Seite 449, Figur 3). Dieser Flußtransformator umfaßt eine als Antenne dienende Feldspule, auch Detektionsschleife genannt, die mit einer Koppelspule zur Einkopplung des Meßsignals in das SQUID verbunden ist. Diese supraleitenden Teile der Vorrichtung können insbesondere als Dünnfilmstruktur ausgebildet sein. Dem aus Flußtransformator und SQUID-Sensor gebildeten supraleitenden Teil der Vorrichtung ist eine rauscharme Elektronik nachgeschaltet.

Zur weiteren Herabsetzung des Rauschens ist darüber hinaus bekannt, für derartige Meßvorrichtungen Gleichstrom(DC)-SQUIDs zu verwenden (vgl. z .B. "Applied Physics Letters", Vol. 40, No. 8, 15.4.1982, Seiten 736 bis 738).

Will man jedoch quasi-statische Magnetfelder mit Frequenzen von z.B. 0,01 Hz bei Meßzeiten im Sekundenbereich messen, so sind die bekannten Vorrichtungen wegen des erwähnten, unterhalb von etwa 1 Hz einsetzenden 1/f-Rauschens des SQUID-Sensors bisher nicht zu nutzen. Dies trifft insbesondere für Felder von entfernten Quellen zu, die nicht beeinflußt, z.B. moduliert werden können und die sehr wenig homogen sind. In diesem Falle lassen sich Magnetometer verwenden, bei denen in allgemein bekannter Weise durch Vibration einer Detektionsspule ein moduliertes Signal erzeugt wird. Analog zu dieser Verfahrensweise kann man auch die Modulation durch Bewegung einer magnetisierbaren Probe relativ zu einer Detektionsspule hervorrufen (vgl. z.B. das Buch von B.I.Bleaney und B. Bleaney: "Electricity and Magnetism", 3. Auflage, 1976, Seite 187). Für den genannten extrem niedrigen Frequenzbereich müßte dann aber die charakteristische Länge der so zu erzeugenden Feldvariation viel größer als die Abmessungen des SQUID-Sensors bzw. seines ihn umgebenden Kühlmittelbehälters sein. Außerdem ist mit dem für die bewegte Probe vorgesehenen ferromagnetischem Material ein hinreichend geringes Flußrauschen nicht zu bewirken.

Zwar beschreibt auch die US-A-3 454 875 eine Anordnung, bei der ebenfalls eine Modulation der Induktivität einer einzigen Spule mittels einer bewegten supraleitenden Platte vorgenommen wird. In der Schrift ist jedoch die Problematik nicht angesprochen, die bei einem SQUID-Magnetometer durch das 1/f-Rauschen an sich begrenzte minimale Grenzfrequenz so weit herabzusenken, daß sich mit dem Magnetometer auch extrem niederfrequente Felder mit Frequenzen von weit unter 1 Hz detektieren lassen. Ein Flußtransformator mit Wicklungen, die ein Koppelloch umschließen, ist dabei nicht vorgesehen.

Zur Herabsetzung der durch das 1/f-Rauschen eines DC-SQUIDs begrenzten minimalen Meßfrequenz sind zwar ferner aus "Applied Physics Letters", Vol. 49, No. 20, 17.11.1986, Seiten 1393 bis 1395 elektronische Schaltungsmaßnahmen bekannt. Mit diesen Maßnahmen lassen sich jedoch nur die durch Fluktuationen des kritischen Stromes des DC-SQUIDs bedingten Rauschanteile unterdrücken. Die einem magnetischen Flußrauschen entsprechenden Rauschanteile können aber auch mit den bekannten Schaltungsmaßnahmen nicht vermindert werden.

Aufgabe der vorliegenden Erfindung ist es somit, die eingangs genannte Meßvorrichtung dahingehend auszugestalten, daß mit ihr auf verhältnismäßig einfache Weise auch quasi statische Magnetfelder mit Frequenzen weit unter etwa 1 Hz, insbesondere unter 0,1 Hz, mit der für SQUID-Magnetometer typischen hohen Magnetfeldempfindlichkeit zu detektieren sind. Dabei sollen die erwähnten, auf ein magnetisches Flußrauschen zurückzuführenden Rauschanteile zu vermindern sein.

Diese Aufgabe wird erfindungsgemäß mit den im zweiten, kennzeichnenden Teil des Anspruchs 1 angegebenen Maßnahmen gelöst.

Mit dem in Dünnfilmtechnik zu erstellenden Flußtransformator bzw. mit Teilen von ihm wird also erfindungsgemäß eine auch als Effektmodulation bezeichnete Modulation des mit der Detektionsspule oder -schleife des Flußtransformators empfangenen Signals vorgenommen. Hiermit läßt sich der Vorteil erreichen, daß die Meßfrequenz in einen Arbeitsbereich des SQUIDs verlagert werden kann, in dem ein rauscharmer Betrieb zu gewährleisten ist. Dieser Frequenzbereich liegt im allgemeinen über 1 Hz. Die entsprechenden Maßnahmen zur Modulation erstrecken sich dabei auf die Gegeninduktivität der beiden Wicklungen eines als Transformatorglied bezeichneten Teiles der Meßvorrichtung. Dieses Transformatorglied kann dabei entweder in den Flußtransformator integriert sein; oder aber nur eine als Koppelspule bezeichnete Wicklung dieses Transformatorgliedes ist dem Flußtransformator zuzurechnen, während die zweite Wicklung Teil einer Schleife des SQUID-Sensors ist. Zur Modulation dient vorteilhaft ein supraleitender Schwingspiegel, der eine mit supraleitendem Material belegte Schwingmembran aufweist. Diese Membran ist als eine Mikrostruktur aus einem zweiten Trägerelement aus zumindest teilweise einkristallinem Silizium herausgearbeitet. Dieses zweite Trägerelement soll vorteilhaft an ein erstes Trägerelement angefügt werden, welches zumindest zum Teil die Wicklungen des Flußtransformators trägt.

Die nicht-vorveröffentlichte, gemäß Art. 54 (3) EPÜ als Stand der Technik geltende EP-A-0 212 452 offenbart zwar eine Vorrichtung zur Messung sich nur mit extrem geringer Frequenz ändernder magnetischer Felder mittels eines SQUID-Magnetometers. Das Magnetometer weist auch einen supraleitenden Flußtransformator zur induktiven Einkopplung des Meßsignals in einen Gleichstrom-SQUID-Sensor auf. Dabei ist zumindest dem Flußtransformator eine Einrichtung zur Modulation des in den SQUID-Sensor einzukoppelnden Meßsignals zugeordnet, deren Modulationsfrequenz ebenfalls in einem für einen rauscharmen Betrieb des SQUIDs charakteristischen Frequenzbereich liegt. Bei dieser Vorrichtung ist jedoch als Modulationseinrichtung eine supraleitende Ringschleife vorgesehen. Außerdem fehlen in dieser Schrift jegliche Hinweise auf besondere, aneinander zu fügende Trägerelemente.

Vorteilhafte Ausgestaltungen der Meßvorrichtung nach der Erfindung gehen aus den abhängigen Ansprüchen hervor.

Zur weiteren Erläuterung der Erfindung und deren mit den abhängigen Ansprüchen gekennzeichneten Weiterbildungen wird auf die schematische Zeichnung Bezug genommen, in deren Figur 1 ein Schaltungsschema zu einer Modulationseinrichtung einer erfindungsgemäßen Meßvorrichtung angedeutet ist. Figur 2 zeigt eine entsprechende Modulationseinrichtung. Aus Figur 3 geht ein Schnitt durch diese Modulationseinrichtung nach Figur 2 hervor, während Figur 4 eine Schwingmembran dieser Modulationseinrichtung zeigt. In den Figuren 5 und 6 ist ein weiteres Ausführungsbeispiel einer Modulationseinrichtung veranschaulicht. Die Figuren 1,2, 5 und 6 sind dabei im wesentlichen der genannten, nicht-vorveröffentlichten EP-A-0 212 452 entnommen. In allen Figuren sind übereinstimmende Teile mit denselben Bezugszeichen versehen.

Gemäß dem Schaltungsschema nach Figur 1 enthält die erfindungsgemäße Meßvorrichtung ein Gleichstrom(DC)-SQUID 2 mit zwei Josephson-Tunnelelementen 3 und 4. An das SQUID ist induktiv ein supraleitender Flußtransformator 5 über eine auch als Koppelspule 6 bezeichnete Wicklung angekoppelt. Neben dieser Koppelspule enthält der Flußtransformator 5 zum Empfang des zu messenden Magnetfeldes mindestens eine weitere Wicklung, die als Detektions- oder Sensorschleife 8 bezeichnet wird. Diese Schleife ist über supraleitende Verbindungsleiter 9 an die Koppelspule 6 angeschlossen. Ströme in dem Flußtransformator werden in bekannter Weise vor Beginn der eigentlichen Messung auf Null gebracht. Ein derartiges Nullen der Transformatorströme läßt sich z.B. mittels über Lichtleiter zuzuführender Wärmeimpulse vornehmen. Auch kann der Flußtransformator durch eine besondere Gegenkopplung stromlos gemacht werden. Außerdem sind im allgemeinen konstante Hintergrundfelder und Störfelder der Umgebung zu kompensieren.

Wie aus dem Schaltungsschema der Figur 1 ferner hervorgeht, ist erfindungsgemäß eine Modulation der Gegeninduktivität M zwischen dem supraleitenden Flußtransformator 5 und dem ihm zugeordneten SQUID 2 vorgesehen. Hierzu wird, anders als bei Gravitationswellendetektoren (vgl. z.B. "IEEE Transactions on Magnetics", Vol. MAG-19, No. 3, Mai 1983, Seiten 461 bis 468), bei denen sich die Gegeninduktivität mit einer bewegten Testmasse verändert, der Strom in dem Flußtransformator vor Beginn der Messung auf Null gebracht. Dann führen nämlich lediglich die kleinen Änderungen des zu messenden Feldes zu Strömen in dem Flußtransformator, deren Wirkung auf das SQUID in der gewünschten Weise moduliert wird. Diese Modulation soll dabei mit einer solchen Frequenz erfolgen, daß das Meßsignal in einen Frequenzbereich des SQUIDs 2 verlagert wird, in dem ein rauscharmer Betrieb zu gewährleisten ist. Entsprechende Modulationsfrequenzen liegen im allgemeinen über 1 Hz, vorzugsweise über 100 Hz, z.B. über 1kHz.

Um für die Schaltung nach Figur 1 die Effektivität des Flußtransformators 5, den sogenannten "Flußtransfer", möglichst groß zu halten, wird entsprechend dem in Figur 2 schematisch als Schrägansicht angedeuteten Ausführungsbeispiel von einem an sich bekannten DC-SQUID 2 ausgegangen. Dieses SQUID ist zusammen mit den ihm zugeordneten Teilen des Flußtransformators 5 in Dünnfilmtechnik erstellt (vgl. "IEEE Transactions on Magnetics", Vol. MAG-17, No. 1, Januar 1981, Seiten 400 bis 403). Das SQUID 2 weist eine breite, ringförmige Schleife 10 aus supraleitendem Material auf, die auf einer Seite durch einen schmalen Spalt oder Schlitz 12 unterbrochen ist und dort in zwei nach außen führende, z.B. schmale Leiterbahnen 13 und 14 mündet. Zur Optimierung der Flußeinkopplung in das SQUID, d.h. zur Minimierung der Verluste im Spalt 12, wird vorteilhaft der Spalt durch eine besondere, in der Figur nicht gezeigte Abdeckung oder durch Überlappung der beiden Leiterbahnen verschlossen. In dem nach außen führenden Bereich der Leiterbahnen 13 und 14 sind die für ein DC-SQUID charakteristischen beiden Josephson-Tunnelelemente 3 und 4 ausgebildet. Auf der ringförmigen Schleife 10 befinden sich ferner die Windungen der flachen Koppelspule 6 des Flußtransformators 5.

Die Schleife 10 und die Koppelspule 6 bilden somit die beiden Wicklungen eines an sich bekannten Transformatorgliedes, das in der Figur allgemein mit 15 bezeichnet ist.

Die ringförmige Schleife 10 des DC-SQUIDs 2 umschließt ein kleines, beispielsweise kreisförmiges oder quadratisches Koppelloch 20 mit einer Seitenausdehnung a von z.B. etwa 50 µm. Erfindungsgemäß soll nun dieses Koppelloch und damit die Gegeninduktivität des Transformatorgliedes 15 moduliert werden. Hierzu dient ein supraleitender Schwingspiegel, der eine mit supraleitendem Material belegte Schwingmembran 21 aufweist. Als supraleitendes Material sollte vorteilhaft ein Werkstoff gewählt werden, dessen kritische Temperatur niedriger als diejenige des Materials des Flußtransformators 5 ist. Auf diese Weise läßt sich gewährleisten, daß vor der eigentlichen Messung dort auftretende Ströme durch kontrolliertes Heizen genullt bzw. eingefroren werden können. Die Schwingmembran 21, die beispielsweise magnetisch, piezoelektrisch, akustisch oder mechanisch bewegt wird, ist nur wenige Mikrometer von der Dünnfilmstruktur des SQUIDs 2 bzw. dessen ringförmiger Schleife 10 entfernt angeordnet. Wie in der Figur durch einen Doppelpfeil 22 angedeutet sein soll, verschließt diese Schwingmembran 21 das Koppelloch 20 mit der vorbestimmten Modulationsfrequenz mehr oder weniger.

Die Ausbildung der in Figur 2 angedeuteten Modulationseinrichtung geht aus dem schematischen Querschnitt der Figur 3 näher hervor. Aus dieser Figur ist ein Chip 25 zu entnehmen, der insbesondere aus Silizium besteht und als ein erstes Tragerelement für das gesamte DC-SQUID und vorteilhaft zumindest auch für die Koppelspule des Flußtransformators dient. Der Bereich des Koppelloches 20 auf der oberen Flachseite 26 des Chips 25 ist durch gestrichelte Begrenzungslinien 20a angedeutet. Auf dieser Flachseite 26 befinden sich außerdem die einzelnen supraleitenden Leiterbahnen der Koppelspule und des SQUIDs. Sie sind durch eine verstärkte Linie 28 veranschaulicht. Auf diesem Chip 25 ist nun als ein zweites Trägerelement ein sogenannter Gegenchip 30 aufgesetzt, wobei für einen sicheren Sitz z.B. geätzte Paßstrukturen 31 in dem Chip 25 und dem Gegenchip 30 sowie Stege 32 sorgen. Zur Verhinderung von Beschädigungen der einzelnen Leiterbahnen 28 bei Kontakt sind in dem Gegenchip 30 an den entsprechenden Stellen Aussparungen 33 vorgesehen. Die Rückseite des Gegenchips 30 ist mit einer supraleitenden Fläche, einer sogenannten "Groundplane" 35 belegt. Wie in der Figur durch einen Pfeil 36 angedeutet sein soll, kann der Gegenchip 30 durch eine auf die Fläche 35 wirkende Preßkraft von der Rückseite her an den Chip 25 angepreßt werden.

Gemäß dem dargestellten Ausführungsbeispiel wurde angenommen, daß in dem Gegenchip 30 besondere Aussparungen 33 vorzusehen sind, um Beschädigungen der einzelnen Leiterbahnen 28 vorzubeugen. Dies läßt sich ebensogut aber auch mittels besonderer Abstandselemente gewährleisten, die zwischen den beiden Chips 25 und 30 vorgesehen werden.

Ferner brauchen die beiden Chips 25 und 30 auch nicht unbedingt mittels einer Preßkraft aneinandergefügt zu sein. Stattdessen ist auch eine Verklebungstechnik möglich.

Erfindungsgemäß ist der Gegenchip 30 mit einer Schwingmembran 21 versehen, die in einem Sicherheitsabstand s von wenigen Mikrometern genau gegenüber dem auf den Chip 25 befindlichen Koppelloch 20 angeordnet ist. Diese Schwingmembran ist in Figur 4 in Aufsicht veranschaulicht. Die Membran wird aus einem als Gegenchip 30 dienenden, einkristallinen Silizium-Plättchen (Si-Wafer) nach einem als "Mikromechanik (Micromechanics)" bezeichneten Verfahren hergestellt. Dieses Verfahren ist eingehend in der Veröffentlichung "Microelectronic Engineering", Vol. 3, 1985, Seiten 221 bis 234 beschrieben. Hierbei wird von hochentwickelten Verfahren der Fotolithographie und der Ätztechniken Gebrauch gemacht, um komplizierte Strukturen aus Silizium im Mikrometerbereich erstellen zu können. Die gezeigte Schwingmembran 21, die von hochelastischen Spiralteilen 38 und 39 gehalten wird, stellt eine derartige Struktur mit hoher mechanischer Güte dar. Ihre Dicke beträgt dabei nur wenige Mikrometer. Die Membran ist in Figur 4 als Ausschnitt 30a aus einem als Gegenchip 30 dienenden Si-Plättchen in einer Darstellung wiedergegeben, die gegenüber Figur 3 wesentlich vergrößert ist. Mit dieser Schwingmembran 21 ist quasi ein Silizium-Resonator auszubilden, der auf seiner dem Koppelloch 20 zugewandten Vorderseite mit dem supraleitendem Material belegt ist.

Zur Anregung der Schwingungen des so ausgebildeten Resonators mit der vorbestimmten Modulationsfrequenz kann insbesondere innerhalb des Koppelloches 20 auf dem Chip 25 eine entsprechende, planare Erregerspule dienen. Diese Erregerspule wird vorteilhaft in Form eines Gradiometers aus zwei Teilspulen realisiert, die gegenseitig kompensatorisch wirken (vgl. z.B. die Veröffentlichung "SQUID '85" (Verlag W.d.Gruyter, 1985), Aufsatz von C.D.Tesche: "Design of compensated planar input coils for biomagnetic measurements"). Die Zuleitungen für diese Erregerspule werden dabei als Streifenleiter oder auf supraleitenden Groundplanes aus dem Bereich des Transformatorgliedes nach außen herausgeführt. Um ein in erster Näherung nicht vorhandenes Übersprechen des Resonator-Erregerfeldes zu kompensieren, kann gegebenenfalls darüber hinaus auf dem Chip 25 eine besondere Gegenkopplungswicklung ausgebildet sein.

Abweichend von der anhand den Figuren 1 bis 3 angedeuteten Modulationsart der Gegeninduktivität bezüglich des SQUIDs besteht ferner die Möglichkeit, den Flußtransformator in bekannter Weise in zwei Stufen aufzuteilen (vgl. z.B. "IEEE Transactions on Magnetics", Vol. MAG-19, No. 3, 1983, Seiten 303 bis 307). Ein entsprechendes Schaltungsschema geht aus Figur 5 hervor. Der dort mit 40 bezeichnete Flußtransformator enthält dementsprechend zwei schleifenartige, elektrisch in sich geschlossene Stufen 41 und 42, die jeweils quasi einzelne Flußtransformatoren darstellen und in denen Ströme J₁ bzw. J₂ fließen. Die Kopplung zwischen diesen Stufen mit einer Gegeninduktivität Mʹ erfolgt dabei über ein in an sich bekannter Weise als Flachspulentransformator aufgebautes Transformatorglied 44 (vgl. z.B. US-PS 3 184 674). Die den Stufen 41 und 42 zuzuordnenden Transformatorwicklungen dieses Transformatorgliedes 44 sind in der Figur mit 45 und 46 bezeichnet.

Das Transformatorglied 44 ist in Figur 6 schematisch als Aufsicht näher ausgeführt. Es enthält zwei integrierte Dünnfilmwicklungen 45 und 46, die durch eine strichpunktierte bzw. durchgezogene Linie veranschaulicht sind. Diese Wicklungen sind gemeinsam und übereinanderliegend auf einem geschlitzten Ring 47 mit überlappendem bzw. abgedecktem Schlitz 48 und Koppelloch 49 aufgebracht. Die mit 50 bezeichnete Schlitzabdeckung ist durch eine gestrichelte Linie angedeutet. Somit entspricht dieses Transformatorglied 44 weitgehend dem in den Figuren 1 und 2 gezeigten Transformatorglied 15, wenn davon abgesehen wird, daß hier der Ring 47 keine Josephson-Elemente aufweist. Wie bei der Ausführungsform nach Figur 2 wird auch hier eine Modulation der effektiven Größe des Koppelloches 49 mit einer supraleitenden Schwingmembran 21 vorgenommen, die Teil eines Gegenchips ist, der auf einem Chip anzuordnen ist, welcher unter anderem das in Figur 6 gezeigte Koppeltransformatorglied 44 trägt. Der von der Schwingmembran 21 geometrisch abgedeckte Teil des Koppelloches 49 ist in der Figur durch eine Schraffur veranschaulicht. Vor Beginn der Messung werden die beiden Ströme J₁ und J₂ in den Dünnfilmwicklungen 45 bzw. 46 in der beschriebenen Weise genullt. Bei der anhand den Figuren 5 und 6 angedeuteten Modulationsmöglichkeit läßt sich ein übliches Trägerfrequenzverfahren zum Auslesen des SQUID-Signals verwenden.

Gemäß den dargestellten Ausführungsbeispielen wurde davon ausgegangen, daß sich das Transformatorglied 15 oder 44, welches das Koppelloch 20 bzw. 49 umschließt, vollständig auf dem das SQUID 2 tragenden Chip 25 befindet. Gegebenenfalls ist es jedoch auch möglich, Teile des Transformatorgliedes wie z.B. die Koppelspule 6 des Transformatorgliedes 15 auf dem Gegenchip 30 anzuordnen.

## Patentansprüche

1. Vorrichtung zur Messung sich nur mit extrem geringer Frequenz ändernder magnetischer Felder mittels eines SQUID-Magnetometers, das einen supraleitenden Flußtransformator (5, 40) zur induktiven Einkopplung des Meßsignals in einen Sensor mit einem Gleichstrom-SQUID (2) aufweist und das eine Einrichtung zur Modulation des Meßsignals enthält, **dadurch gekennzeichnet,** daß dem in Dünnfilmtechnik erstellten Flußtransformator (5, 40) zwei induktiv gekoppelte, ein Transformatorglied (15, 44) bildende Wicklungen (6, 10 bzw. 45, 46) zugeordnet sind, die ein gemeinsames Koppelloch (20, 49) umschließen, wobei mindestens eine der Wicklungen (6, 10 bzw. 45, 46) auf einem ersten Trägerelement (25) angeordnet ist, daß an das erste Trägerelement (25) ein zweites Trägerelement (30) angefügt ist, das zumindest teilweise aus einkristallinem Silizium besteht und gegenüber dem Koppelloch (20, 49) als ein supraleitender Schwingspiegel ausgebildet ist, der eine mit supraleitendem Material belegte, als eine Mikrostruktur aus dem zweiten Trägerelement (30) herausgearbeitete Schwingmembran (21) aufweist, und daß die Gegeninduktivität (M, M') der Wicklungen (6, 10, 45, 46) mittels dieses supraleitenden Schwingspiegels durch entsprechende Änderung der effektiven Größe des Koppelloches (20, 49) mit einer Frequenz zu modulieren ist, die in einem für einen rauscharmen Betrieb des SQUIDs (2) charakteristischen Frequenzbereich liegt.

2. Vorrichtung nach Anspruch 1, **dadurch gekennzeichnet,** daß der Flußtransformator (40) in zwei einzelne, kleinere Flußtransformatoren (41, 42) bildende Stufen aufgeteilt ist, die über die Wicklungen (45, 46) des Transformatorgliedes (44) induktiv gekoppelt sind.

3. Vorrichtung nach Anspruch 1, **dadurch gekennzeichnet,** daß die erste Wicklung des Transformatorgliedes (15) eine Koppelspule (6) des Flußtransformators (5) ist, während die zweite Wicklung durch eine Schleife (10) des SQUIDs (2) gebildet ist.

4. Vorrichtung nach einem der Ansprüche 1 bis 3, **dadurch gekennzeichnet,** daß eine Modulationsfrequenz über 1 Hz, vorzugsweise von über 100 Hz vorgesehen ist.

5. Vorrichtung nach einem der Ansprüche 1 bis 4, **dadurch gekennzeichnet,** daß auf der Schwingmembran (21) ein supraleitendes Material abgeschieden ist, das eine niedrigere kritische Temperatur (T_{c}) als das supraleitende Material des Flußtransformators (5, 40) hat.

6. Vorrichtung nach einem der Ansprüche 1 bis 5, **dadurch gekennzeichnet,** daß die Schwingmembran (21) mittels einer innerhalb des Koppelloches (20, 49) angeordneten planaren Erregerspule in Schwingungen zu versetzen ist, welche in Form eines Gradiometers aus zwei gegenseitig kompensatorisch wirkenden Teilspulen ausgebildet ist.

7. Vorrichtung nach einem der Ansprüche 1 bis 6, **dadurch gekennzeichnet,** daß die erste Wicklung des Transformatorgliedes (15, 44) auf dem ersten Trägerelement (25) angeordnet ist, während sich die zweite Wicklung auf dem zweiten Trägerelement (30) befindet.

## Claims

1. Device for the measuring of magnetic fields of extremely low frequency by means of a SQUID magnetometer which contains a superconductive flux transformer (5, 40) for the inductive coupling of the measuring signal into a sensor with a direct current SQUID (2) and which is provided with a device for the modulation of the measuring signal, characterised
- in that two windings (6, 10 reap. 45, 46) inductively coupled and forming a transformer element (15, 44) and enclosing a common coupling hole (20, 49) are associated with the flux transformer (5, 40) made by thin film technology, whereby at least one of the windings (6, 10 reap. 45, 46) is placed on a first carrier element (25),
- in that a second carrier element (30) is attached onto the first carrier element (25) and consists at least partially of single-crystalline silicon and is formed as a superconductive mirror oscillating relative to the coupling hole (20, 49), which mirror contains an oscillating membrane (21) coated by the superconductive material and fabricated as a microstructure of the second carrier element (30),
- and in that the mutual inductance (M, M') of the windings (6, 10, 45, 46) can be modulated by this superconductive oscillating mirror by means of the corresponding change of the effective size of the coupling hole (20, 49) with a frequency lying in a frequency range for low noise operation of the SQUID (2).

2. Device according to claim 1, characterised in that the flux transformer (40) is subdivided into two individual steps forming smaller flux transformers (41, 42) which are inductively coupled by the windings (45, 46) of the transformer element (44).

3. Device according to claim 1, characterised in that the first winding of the transformer element (15) is a coupling coil (6) of the flux transformer (5) whereas the second winding is formed by a loop (10) of the SQUID (2).

4. Device according to one of claims 1 to 3, characterised in that a modulation frequency above 1 Hz, preferably above 100 Hz, is provided.

5. Device according to one of claims 1 to 4, characterised in that a superconductive material is deposited onto the oscillating membran (21) with a transition temperature (T_{c}) lower than these of the superconductive material of the flux transformer (5, 40).

6. Device according to one of claims 1 to 5, characterised in that the oscillating membran (21) is excited to oscillations by means of a planar exciting coil arranged inside the coupling hole (20, 49) in a configuration of a gradiometer of two mutually compensating coil parts.

7. Device according to one of claims 1 to 6, characterised in that the first winding of the transformer element (15, 44) is disposed onto the first carrier element (25) whereas the second winding is placed onto the second carrier element (30).

## Revendications

1. Dispositif pour la mesure de champs magnétiques de fréquence extrêmement bas à l'aide d'un magnétomètre à SQUID étant pourvu d'un transformateur supraconducteur de flux magnetique (5, 40) pour introduire inductivement le signal de mesure dans un détecteur avec un SQUID à courant continu (2) et comportant un dispositif pour la modulation du signal de mesure, caractérisé par le fait
- que deux bobinages (6, 10 resp. 45, 46) inductivement couplés et formant un élément de transformateur (15, 44) sont associés au transformateur de flux (5, 40) qui est réalisé selon la technique des couches minces, lesquels bobinages entourent une ouvertue de couplage commune (20, 49), au moins un des bobinages (6, 10 resp. 45, 46) est situé sur un premier élément de support (25),
- qu'un deuxième élément de support (30) est joint au premier élément de support (25) et consiste au moins d'un part de silicium monocristallin et est formé comme un miroir supraconducteur et oscillant rélativement à l'ouverture de couplage (20, 49), lequel miroir contient une membrane oscillante (21) qui est couverte du matériau supraconducteur et est faite ressortir du deuxième élément de support (30) comme une microstructure,
- et que l'inductance mutuelle (M, M') des bobinages (6, 10, 45, 46) est moduleé à l'aide de ce miroir supraconducteur et oscillant par changement de la grandeur effective de l'ouverture de couplage (20, 49) avec une fréquence qui se situe dans une gamme de fréquence qui est caractéristique pour un fonctionnement à faible bruit du SQUID (2).

2. Dispositif selon la revendication 1, caractérisé par le fait que le transformateur de flux (40) est partagé en deux étages particuliers qui forment des transformateurs de flux plus petits (41, 42) et qui sont couplés inductivement par les bobinages (45, 46) de l'élément de transformateur (44).

3. Dispositif selon la revendication 1, caractérisé par le fait que le premier bobinage de l'élément de transformateur (15) est une bobine de couplage (6) tandis que le deuxième bobinage est formé par une boucle (10) du SQUID (2).

4. Dispositif selon l'une des revendications 1 à 3, caractérisé par le fait qu'il est prévu une fréquence de modulation supérieure à 1 Hz, de préférence supérieure à 100 Hz.

5. Dispositif selon l'une des revendications 1 à 4, caractérisé par le fait qu'un matériau supraconducteur est déposé sur la membrane oscillante (21) avec une température de transition (T_{c}) qui est plus basse que celle du matériau supraconducteur du transformateur de flux (5, 40).

6. Dispositif selon l'une des revendications 1 à 5, caractérisé par le fait que la membrane oscillante (21) est excitée à des oscillations à l'aide d'une bobine planare d'excitation qui est arrangée à l'intérieur de l'ouverture de couplage (20, 49) et qui a la configuration d'un gradiomètre consistant de deux bobines partielles qui se compensent mutuellement.

7. Dispositif selon l'une des revendications 1 à 6, caractérisé par le fait que le premier bobinage de l'élément de transformateur (15, 44) est situé sur le premier élément de support (25) tandis que le deuxième bobinage se trouve sur le deuxième élément de support (30).
